(19) Europäisches Patentamt
European Patent Office
Office européen des brevets

(11) EP 1 170 396 A2

(12) EUROPEAN PATENT APPLICATION

(43) Date of publication:
09.01.2002 Bulletin 2002/02

(51) Int Cl.7: C23C 14/54, G02B 5/20

(21) Application number: 01114828.5

(22) Date of filing: 28.06.2001

(84) Designated Contracting States:
AT BE CH CY DE DK ES FI FR GB GR IE IT LI LU MC NL PT SE TR
Designated Extension States:
AL LT LV MK RO SI

(30) Priority: 03.07.2000 JP 2000200913

(71) Applicant: JAPAN AVIATION ELECTRONICS INDUSTRY, LIMITED
Shibuya-ku, Tokyo 150-0043 (JP)

(72) Inventors:
- Nishida, Emiko, Japan Aviation Elec. Ind. Ltd. Tokyo 150-0043 (JP)
- Uehara, Noboru, Japan Aviation Elec. Ind. Ltd. Tokyo 150-0043 (JP)

(74) Representative: Hoffmann, Eckart, Dipl.-Ing.
Patentanwalt, Bahnhofstrasse 103
82166 Gräfelfing (DE)

(54) **Method and apparatus for forming an optical multilayer filter**

(57) In a film forming method for forming an optical multilayer filter by detecting the thickness of each layer by means of an optical thickness monitor (OTM) 15 and by controlling a film forming apparatus 11 based on the OTM detected output: the light source of the OTM 15 is formed by a variable wavelength light source whose wavelength is variable over the range of $\lambda_1$ nm to $\lambda_2$ nm, including X nm; the optical thickness of each of $\lambda/4$-oriented layers is optimized within the range of $\lambda_1/4$ nm to $\lambda_2/4$ nm; the wavelength of the variable wavelength light source 12 for each layer is selected so that its transmittance reaches an extreme value at the optical thickness of each layer; and the formation of each layer is stopped upon detection of the extreme value of the transmittance.

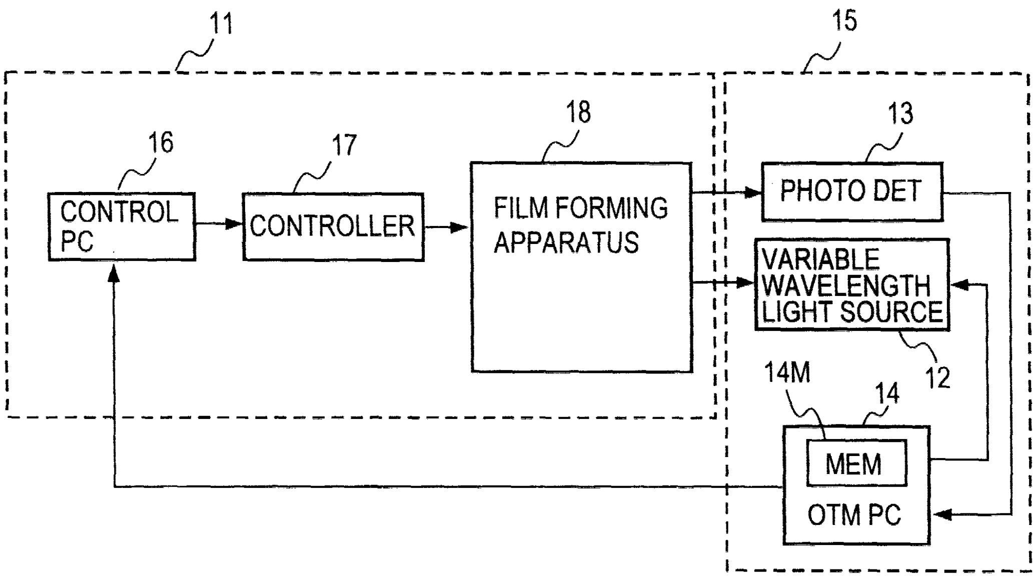


FIG. 15

EP 1 170 396 A2

## Description

BACKGROUND OF THE INVENTION

The present invention relates to a method and apparatus suitable for use in forming respective films of an optical multilayer filter for use with such as DWDM (Dense Wavelength Division Multiplexing) and EDFA (Erbium Doped Fiber Amplifier) applications.

Recently, in the field of optical communications there is a growing demand for filters for DWDM and EDFA (hereinafter referred to as DWDM/EDFA filters) which are required to meet highly exacting specifications in terms of loss, ripple and band, and hence they are extremely high in the degree of difficulty in forming individual films to required thicknesses.

Fig. 1 shows, by way of example, optical characteristics of blue- and red-band filters which are most difficult in film formation among the filter DWDM/EDFA filters, in comparison with the optical characteristics of a conventional WDM filter for use in a 1.3/1.5 μm band. Since pass and stop bands are spaced only several nm apart, the blue- and red-band filters have a very sharp and steep characteristic as compared with that of the conventional WDM filter.

Fig. 2 shows an example of the optical characteristics of such a DWDM/EDFA filter in the case where $Ta_2O_5$ and $SiO_2$ are used as film materials, the total number of layers is 78 and the optical thickness of each layer is $\lambda/4$. In Fig. 2 a curve of thick line corresponds to the left-hand ordinate and a curve of thin like which represents a the magnified-topped of the curve of thick line corresponds to the right-hand ordinate. The hatched frames indicate target optical characteristics (band, loss).

In this example the pass band and the loss virtually reach target values but the ripple is large and fails to meet the specifications for the DWDM/EDFA filter that the ripple is required to be, for instance, 0.05 dB or below.

On the other hand, it is customary in the art to control the film formation of this kind of high precision multilayer filter by the use of an optical thickness monitor (hereinafter referred to as OTM) that optically detects the film thickness through utilization of interference of light, instead of using a conventional oscillator thickness monitor. The OTM launches light of a predetermined wavelength (hereinafter referred to as a monitor wavelength) into the film being formed, then detects, for example, the transmitted light, and measures the film thickness based on variations in the film transmittance due to changes in interference of light that are caused as the film formation proceeds.

Figs. 3 to 5 show variations in the transmittance of the above-mentioned filter with increase in film thickness from 0 to 10000 nm, from 10000 to 20000 nm and from 20000 to 27000 nm, respectively, as the number of layers increases during formation of the multilayer filter. The transmittance is calculated with the OTM monitor wavelength set at λ nm (1550 nm in this example). The lower abscissa represents the accumulated physical film thickness starting with the first layer. A numeral, j, which is any one of the numerals 1, 2, ..., 78 along the upper abscissa indicates a j-th layer. If layers are formed in this numeric order, the abscissa corresponds to the lapse of time.

A description will be given of a method for calculating the transmittance and reflectivity of an interim multilayer film formed until a given point in time when individual layers are sequentially formed on a substrate. Fig. 6 is a schematic showing of the reflectivity and transmittance of the multilayer film. Fig. 6 shows how the transmittance T or reflectivity R of an interim multilayer film 21M composed of first to L-th layers formed on a substrate 21S. In this example, the monitor light is incident from the side opposite the substrate 21S.

The amplitude reflection Fresnel coefficient r and transmission Fresnel coefficient t of the monitor light incident to the L-th layer, which is the uppermost layer at the current point in time, are expressed as follows:

$$r = (\eta_m E_m - H_m)/(\eta_m E_m + H_m) \qquad (1)$$

$$t = 2\eta_m/(\eta_m E_m + H_m) \qquad (2)$$

where $\eta_m$ is the effective reflection of the multilayer film as viewed from a medium of incidence (hereinafter referred to as incidence-medium) 31. In general, the effective reflection coefficient η is given by the following equation

$$\eta = \begin{bmatrix} n/\cos\theta \\ n\cos\theta \end{bmatrix} \qquad (3)$$

where $n/\cos\theta$ is polarized light and $n\cos\theta$ is s-polarized light.

$E_m$ and $H_m$ are an electric field vector and a magnetic field vector in the incidence-medium 31, respectively, and they are given by

$$\begin{bmatrix} E_m \\ H_m \end{bmatrix} = M \begin{bmatrix} 1 \\ \eta_s \end{bmatrix} \quad (4)$$

where $\eta_s$ is the effective reflection coefficient of the substrate 21S as viewed from the first layer and M is called a characteristic matrix of the multilayer film 21M and is given by

$$M = M_L\ M_{L-1} \ldots M_j \ldots M_2 M_1 \quad (5)$$

$M_j$ is a 2 by 2 characteristic matrix and is given by

$$M_j = \begin{bmatrix} m_{11} & im_{12} \\ im_{21} & m_{22} \end{bmatrix} = \begin{bmatrix} \cos\delta_j & i\sin\delta_j/\eta_j \\ in_j\sin\delta_j & \cos\delta_j \end{bmatrix} \quad (6)$$

where

$$\delta_j = 2\pi(n_j - ik_j)d_j\cos\theta_j/\lambda \quad (7)$$

$$n_m\sin\theta_0 = n_j\sin\theta_j \quad (8)$$

where $n_j$ and $k_j$ are the refractive index and extinction coefficient of the j-th layer, $n_m$ is the refractive index of the substrate 21S and i is an imaginary number.

Letting the refractive index of the substrate 21S be represented by $n_s$, the transmittance T and reflectivity R of the interim multiplayer film 21M composed from the first to L-th layers are given as follows:

$$T = n_s|t|^2/n_m \quad (9)$$

$$R = |r|^2 \quad (10)$$

As is evident from Figs. 3 to 5, the transmittance of each layer ends with an extreme value since the optical thickness of each layer is designed to be λ/4 in this example.

In the above the optical characteristic of a filter assumed to be composed of 78 layers has been described, but in the case of using the λ/4 optical thickness of each layer, it is difficult to meet the specifications for the DWDM/EDFA filter with such a small number of layers. To meet the specifications, it is necessary that the number of layers, for example, be more than 200 and that the allowable error in the formation of each layer (film thickness accuracy) be in the range of 0.01 to 0.1%. Hence, much difficulties are encountered in the actual film formation with such high accuracy.

A main cause for which the required specifications cannot be met with the λ/4 film thickness and a small number of layers is that the ripple in the pass band is large. However, the ripple could be reduced, for example, through optimization of the optical thicknesses of all or some of the layers by selectively setting the thicknesses in the neighborhood of λ/4 without changing the basic design of the λ/4 film structure.

This optimization count be achieved using a commercially available design software for optical thin films. Thus optimized thicknesses $d_1$, $d_2$, ... of first to last layers could be determined.

Fig. 7 is a graph showing optical characteristics of a filter having its thicknesses of layers optimized within the range of $\lambda/4\pm1.3\%$. As will be seen, the ripple goes down below 0.05 dB, satisfying the demanded specifications.

Figs. 8 to 10 show, similarly to Figs. 3 to 5, calculated values of variations of the transmittance of the optimized filter with respect to a 1550 nm OTM monitor wavelength. Since the optical thickness of each layer may be shifted from $\lambda/4$, the transmittance of each layer does not necessarily terminate with an extreme value. For instance, as typically seen in 27th, 28th, 29th, 54th, 55th, 56th, 57th and 58th layers, the transmittance does not take the extreme value at the boundaries between these layers.

Accordingly, in this instance the film formation control by OTM involves the detection of absolute transmittance instead of the detection of relative variations like the detection of extreme values.

While the above description has been given of the scheme that detects transmitted light by OTM, the same goes for the case of detecting reflected light by OTM, too; that is, in the case where the optical thickness of each layer may deviate from $\lambda/4$, it is necessary to detect absolute reflectance instead of detecting relative variations in reflectance.

As described above, in the case of optimizing the optical thicknesses of the $\lambda/4$-oriented layers by changing them, the film formation control by OTM involves the detection of absolute transmittance or absolute reflectivity with high accuracy--this requires, for instance, high sensitivity detector and a light source with high precision wavelength resolving power, giving rise to a problem that OTM (optical system) for film formation control is extremely expensive.

Further, since transmittance and reflectivity are affected, for example, by a temperature change around the substrate during film formation, it is very difficult to detect absolute transmittance or absolute reflectivity of a level corresponding to the permissible accuracy limits of 0.01 to 0.1% required for film thickness control for the DWDM/EDFA filter.

## SUMMARY OF THE INVENTION

It is therefore an object of the present invention to provide a film forming method and apparatus for an optical multilayer filter which, even in the case of optimizing the optical thickness of each $\lambda/4$-oriented layer by setting it in the neighborhood of $\lambda/4$, enable film formation control by the optical thickness monitor (OTM) to be effected by detecting the extreme value of transmittance or reflectivity, and hence permit easy and high precision film formation of an optical multilayer filter that has a high degree of difficulty in film formation, such as the DWDM/EDFA filters.

According to an aspect of the present invention, there is provided a method for forming layers of an optical multilayer filter which comprises the steps of:

(a) determining the wavelength of monitor light for each layer of optimized thickness so that the transmittance or reflectivity of an interim multilayer film with said each layer formed as the outermost layer reaches an extreme value;
(b) setting the wavelength of monitor light to be emitted from a variable wavelength light source to said wavelength determined in said step (a) at the time of forming said each layer, detecting transmitted light through or reflected light by said interim multilayer irradiated with said monitor light, and deciding whether said detected output has reached an extreme value;
(c) stopping the film formation of said each layer when it is decided that said extreme value has been reached; and
(d) repeatedly performing said steps (b) and (c) by a predetermined number of layers.

According to another aspect of the present invention, there is provided an apparatus for forming layers of an optical multilayer filter, comprising:

a film forming apparatus main unit provided with a chamber in which layers of optical multilayer film are formed on a substrate in a sequential order;
a variable wavelength light source for emitting variable wavelength monitor light;
wavelength setting means for setting the wavelength of said variable wavelength light source, for the optical thickness of each layer to be formed, to a wavelength at which the transmittance or reflectivity of an interim multilayer film with said each layer formed as the outermost layer reaches an extreme value;
an optical thickness monitor for detecting transmitted or reflected light of said monitor light incident to said interim multilayer film during the film formation of said each layer and deciding whether an transmittance or reflectivity of said interim multilayer film has reached an extreme value; and
a control device for effecting control to stop the film formation of said outermost layer when it is decided by said optical thickness monitor that said transmittance or reflectivity of said interim multilayer film has reached said extreme value.

BRIEF DESCRIPTION OF THE DRAWINGS

Fig. 1 is a graph showing optical characteristics of a 1.3/1.5 μm WDM filter and a blue/red band filter for DWDM/EDFA use;
Fig. 2 is a graph showing optical characteristics of a filter in which the optical thickness of each of λ/4-oriented layers;
Fig. 3 is a graph showing calculated values of OTM transmittance of the Fig. 2 filter with respect to a 1550 nm monitor wavelength 1st to 27th layers);
Fig. 4 is a continuation of the Fig. 3 graph (27th to 54th layers);
Fig. 5 is a continuation of the Fig. 4 graph (54th to 78th layers);
Fig. 6 is a schematic diagram showing the reflectivity and transmittance of each layer of the multilayer film;
Fig. 7 is a graph showing optical characteristics of a filter with the optical thickness of each layer optimized under predetermined conditions;
Fig. 8 is a graph showing calculated values of OTM transmittance of the Fig. 7 filter with respect to the 1550 nm of monitor wavelength (1st to 27th layers);
Fig. 9 is a continuation of the Fig. 8 graph (27th to 54th layers);
Fig. 10 is a continuation of the Fig. 9 graph (54th to 78th layers);
Fig. 11 is a graph explanatory of an embodiment of the present invention, showing calculated values of OTM transmittance in the case where the optical thickness of each λ/4-oriented layer is optimized and the monitor wavelength is selected for each layer (1st to 27th layers);
Fig. 12 is a continuation of the Fig. 11 graph (27th to 54th layers);
Fig. 13 is a continuation of the Fig. 12 (54th to 78th layers);
Fig. 14 is a flowchart depicting the procedure of the manufacture of the optical multilayer filter according to the present invention;
Fig. 15 is a block diagram illustrating an embodiment of the present invention;
Fig. 16A is a plan view schematically showing a sample holder;
Fig. 16B is a diagram for explaining the principal part of the film forming apparatus according to the present invention;
Fig. 17A is a graph showing a trigger signal synchronized with the rotation of the sample holder; and
Fig. 17B is a graph showing the detected output (OTM signal) from a photodetector.

DETAILED DESCRIPTION OF THE PREFERRED EMBODIMENTS

The mode for carrying out the present invention will be described by way of its embodiment.

In this example the light source of a light interference type optical thickness monitor (OTM) for film formation control is a variable wavelength light source, not a single-wavelength light source used in the past. And the variable wavelength light source is one that its wavelength is variable over the range of $\lambda_1$ nm to $\lambda_2$ nm, including λ nm. Such a variable wavelength light source can be formed, for example, by a laser light source which emits coherent light.

A filter in which the optical thickness of each layer is λ/4 can be optimized by selecting the optical thicknesses of all layers or some of them in the neighborhood of λ/4 as described previously. That is, it is possible to obtain a filter that meets such demanded specifications (namely, required performance characteristics).

In this example, it is assumed that the optical thickness is optimized within the range of $\lambda_1/4$ nm to $\lambda_2/4$ nm that is defined by $\lambda_1$ and $\lambda_2$ in the variable wavelength range of $\lambda_1$ to $\lambda_2$ of the variable wavelength light source.

Setting λ=1550 nm, $\lambda_1$=1480 nm and $\lambda_2$=1580 nm, the optical thickness of each layer of the filter, which has the optical characteristics depicted in Fig. 7, that is, a filter having the optical thickness of each layer optimized within the range of λ/4±1.3%, is in the range of $\lambda_1/4$ nm to $\lambda_2/4$ nm; hence, the wavelength of the variable wavelength light source can be set, for each layer, to a wavelength at which, for example, the transmittance of a multilayer film currently being formed with the said each layer as the outermost layer (which multilayer film will hereinafter be referred to as an interim multilayer film) reaches an extreme value. That is, the transmittance or reflectivity of the interim multilayer film with a j-th layer being formed as the outermost layer is calculated by Eq. (9) or (10) for the wavelength λ of monitor light while changing it from $\lambda=\lambda_1$=1480 nm to $\lambda_2$=1580 nm in steps of 10 nm, for instance, and the wavelength that provides an extreme value of the transmittance or reflectivity is used as the wavelength of the monitor light for the j-th layer.

Figs. 11 to 13 show calculated values of transmittance variations for the wavelengths of monitor light selected for respective layers so that their transmittance would terminate with an extreme value as referred to above. As depicted in Figs. 11 to 13, the transmittance is discontinuous at the boundary between 12th and 13th layers, for instance, but this discontinuity resulted from adjusting the wavelength of monitor light so that the transmittance would reach its extreme value at the boundary between the two layers. Similar discontinuities are found at other boundaries. As is evident from Figs. 11 to 13, according to this example, it is possible to stop the formation of each layer by detecting the extreme value of transmittance.

In other words, according to this example, even in the case where the optical thicknesses of λ/4-oriented layers are optimized, the film formation can be controlled by detecting the extreme value of the transmittance of each layer, that is, by detecting the relative change in transmittance, not by detecting its absolute value.

For example, in the case where there are found, at the end of film formation, a plurality of wavelengths at which the transmittance of the layer being formed reaches its extreme value, that one of the wavelengths which is the highest in transmittance and large in amplitude variation is selected. Since the monitor wavelengths in the reflection band of the filter are difficult to satisfy the above-mentioned conditions, a wavelength in the pass band is chosen.

Fig. 14 is a flowchart showing in brief the method for manufacturing the optical multilayer filter according to the present invention described above.

Step S1: Optimize thickness each layer so that the characteristics of the optical filter become as desired.

Step S2: For each layer having its thickness optimized, determine the wavelength of monitor light so that the transmittance of the interim multilayer film with that layer as the outermost layer, and store the thus determined wavelength in a memory.

Step S3: Initialize a layer number parameter j.

Step S4: Read out the wavelength of monitor light for a j-th layer from the memory, and set the variable wavelength light source to the read-out value.

Step S5: Start the film formation of the j-th layer.

Step S6: Make a check to see if the detected output of monitor light has reached its extreme value.

Step S7: Stop the formation of the j-th layer at the time when the detected output of monitor light has reached its extreme value.

Step S8: Make a check to see if the j-th layer is the last layer of the predetermined multilayer film.

Step S9: If the j-th layer is not the last layer, increment j by one, then return to step S4, and repeat steps S4 to S8; and if the j-th layer is the last layer, end the formation of the multilayer film.

Fig. 15 illustrates in block form a film forming apparatus suitable for such film formation as described above, and Fig. 16B schematically depicts the construction of its principal part.

The film forming apparatus, indicated generally by 11, is an ion beam sputtering film-forming apparatus, for instance. As depicted in Fig. 15, the film forming apparatus 11 is provided with an optical thickness monitor (OTM) that comprises a variable wavelength light source 12, a photodetector 13, and a PC (personal computer) 14 connected to them. The optical thickness monitor 15 optimizes the thickness of each layer of the multilayer film desired to form, then calculates, for each layer, the monitor light wavelength at which the transmittance of the interim multilayer film will reach its extreme value at the time of forming the said each layer as the outermost layer, and prestores the calculated monitor light wavelength in the memory 14.

The OTM PC 14 reads out of the memory 14 the monitor light wavelength predetermined for the formation of each layer, and prior to the formation of the layer, sets the variable wavelength light source 12 to emit light at the read-out wavelength.

The light emitted from the variable wavelength light source 12 is incident on the interim multilayer film being formed, and the transmitted light therefrom is detected by the photodetector 13. The detected output from the photodetector 13 is input to the OTM PC 14, which calculates the transmittance of the interim multilayer film from the detected output and provides a stop signal to a control PC 16 of the film forming apparatus 11 at the same time as the transmittance change passes through an extreme value.

The control PC 16 responds to the stop signal to output a control signal to a controller 17, which, in turn, controls an ion gun or the like to stop the formation of the layer being carried out. Reference numeral 18 denotes a film forming apparatus main unit.

As shown in Fig. 16A, a plurality of sample substrates 21, each for forming thereon the required multilayer film, are mounted on a sample holder 22. The sample holder 22 has a plurality of holes 23, in which the sample substrates are fitted. Incidentally, as depicted, no sample substrate 21 is set in one of the holes 23 for the purpose of measuring the monitor light having passed through the void hole (which light will hereunder be referred to as 100% transmitted light). By using the 100% transmitted light to calibrate sample-transmitted light, the relative transmittance of the interim multilayer film can be calculated with higher accuracy.

The sample holder 22 is mounted on a rotary shaft 24 as shown in Fig. 16B, and is rotated during film formation, and the sample substrates 21 are sequentially irradiated with the monitor light.

The monitor light emitted from the variable wavelength light source 12 is launched into a film forming chamber 25 through a view port 26, wherein the monitor light is reflected by a 45° reflector 28 onto the sample substrates 21. The reflector 28 is fixed by a jig 27 in this example. And, the transmitted light is reflected by the 45° reflector 28 back through the view port 26 to the photodetector 13 disposed outside the film forming chamber 25.

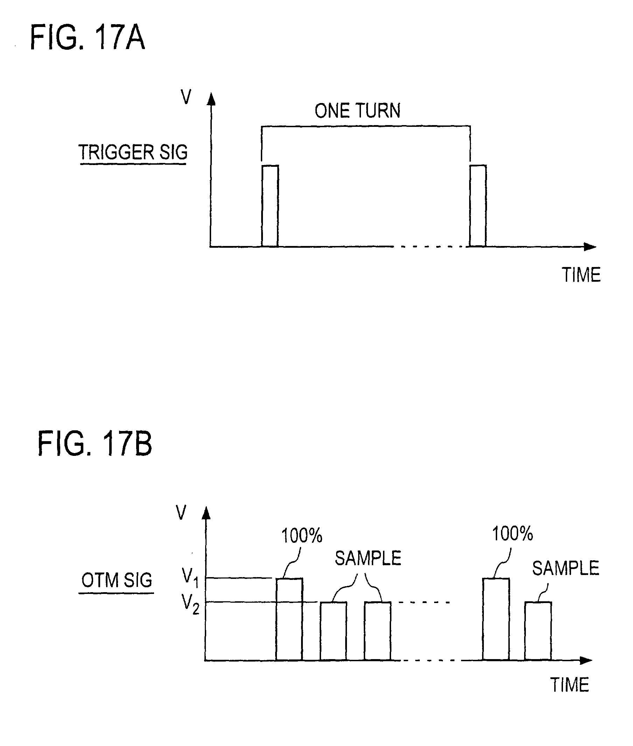

The photodetector 13 provides such an output voltage as shown in Fig. 17B. The OTM PC 14 is triggered by the output from an origin sensor (see Fig. 17A) mounted on the sample holder 22 to detect voltages $V_1$ and $V_2$ for the 100% transmitted light and the sample-transmitted light, respectively, and calculate the transmittance of the sample. The transmittance T(%) of the sample is given by

$$T=(V_2/V_1)\times 100.$$

While the above embodiment has been described to detect transmitted light by OTM, the same results as mentioned above are also obtainable with a configuration that detects reflected light from the film by OTM. That is, in the case where the optical thickness of the λ/4-oriented layer is optimized, it is possible to control the film formation by detecting the extreme value of the reflectivity of the layer, namely by detecting the relative variations of the reflectivity, instead of detecting its absolute value.

## EFFECT OF THE INVENTION

As described above, according to the present invention, even if the optical thickness of each layer of the λ/4-oriented structure is optimized by being selected in the neighborhood of λ/4, the formation of each layer can easily be controlled since the control by the optical thickness monitor (OTM) utilizes the detection of the extreme value of the transmittance or reflectivity of each layer during its formation. Further, since relative variations in transmittance or reflectivity needs only to be detected, the optical system of the optical thickness monitor need not be so high precision and hence expensive as in the case of detecting absolute transmittance or absolute reflectivity of each layer and can be constructed at low cost.

Accordingly, the film forming method of the present invention permits high precision and easy manufacture of an optical multilayer filter even if the film formation is very difficult as in the case of the DWDM/EDFA filter.

It will be apparent that many modifications and variations may be effected without departing from the scope of the novel concepts of the present invention.

## Claims

1. A film forming method for an optical multilayer filter having a predetermined number of layers in which the optical thickness of each of said layers of a λ/4-oriente structure is determined by its optimization in the neighborhood of λ/4, said method comprising the steps of:

   (a) determining the wavelength of monitor light for said each layer of optimized thickness so that the transmittance or reflectivity of an interim multilayer film with said each layer formed as the outermost layer reaches an extreme value;
   (b) setting the wavelength of monitor light to be emitted from a variable wavelength light source to said wavelength determined in said step (a) at the time of forming said each layer, detecting transmitted light through or reflected light by said interim multilayer irradiated with said monitor light, and deciding whether said detected output has reached an extreme value;
   (c) stopping the formation of said each layer when it is decided that said extreme value has been reached; and
   (d) repeatedly performing said steps (b) and (c) by a predetermined number of layers.

2. The method of claim 1, wherein said step 8a) includes a step of, letting two wavelengths in the variable wavelength range of said variable wavelength light source being represented by $\lambda_1$ and $\lambda_2$, optimizing said each layer within the range of $\lambda_1/4$ to $\lambda_2/4$.

3. The method of claim 1, wherein said step (a) includes a step of storing a waveform determined for said each layer in a memory and said step (b) includes a step of reading out of said memory the wavelength corresponding to said each layer.

4. A film forming apparatus for an optical multilayer filter having a predetermined number of layers in which the optical thickness of each of said layers of a λ/4-oriente structure is determined by its optimization in the neighborhood of λ/4, said apparatus comprising:

a film forming apparatus main unit provided with a chamber in which layers of a multilayer film are formed on a substrate in a sequential order;
a variable wavelength light source for emitting variable wavelength monitor light;
wavelength setting means for setting the wavelength of said variable wavelength light source, for the optical thickness of said each layer to be formed, to a wavelength at which the transmittance or reflectivity of an interim multilayer film with said each layer formed as the outermost layer reaches an extreme value;
an optical thickness monitor for detecting transmitted or reflected light of said monitor light incident on said interim multilayer film during the formation of said each layer and deciding whether said transmittance or reflectivity of said interim multilayer film has reached said extreme value; and
a control device for effecting control to stop the formation of said outermost layer when it is decided by said optical thickness monitor that said transmittance or reflectivity of said interim multilayer film has reached an extreme value.

**5.** The apparatus of claim 4, wherein said variable wavelength light source is a variable wavelength laser light source.

FIG. 1

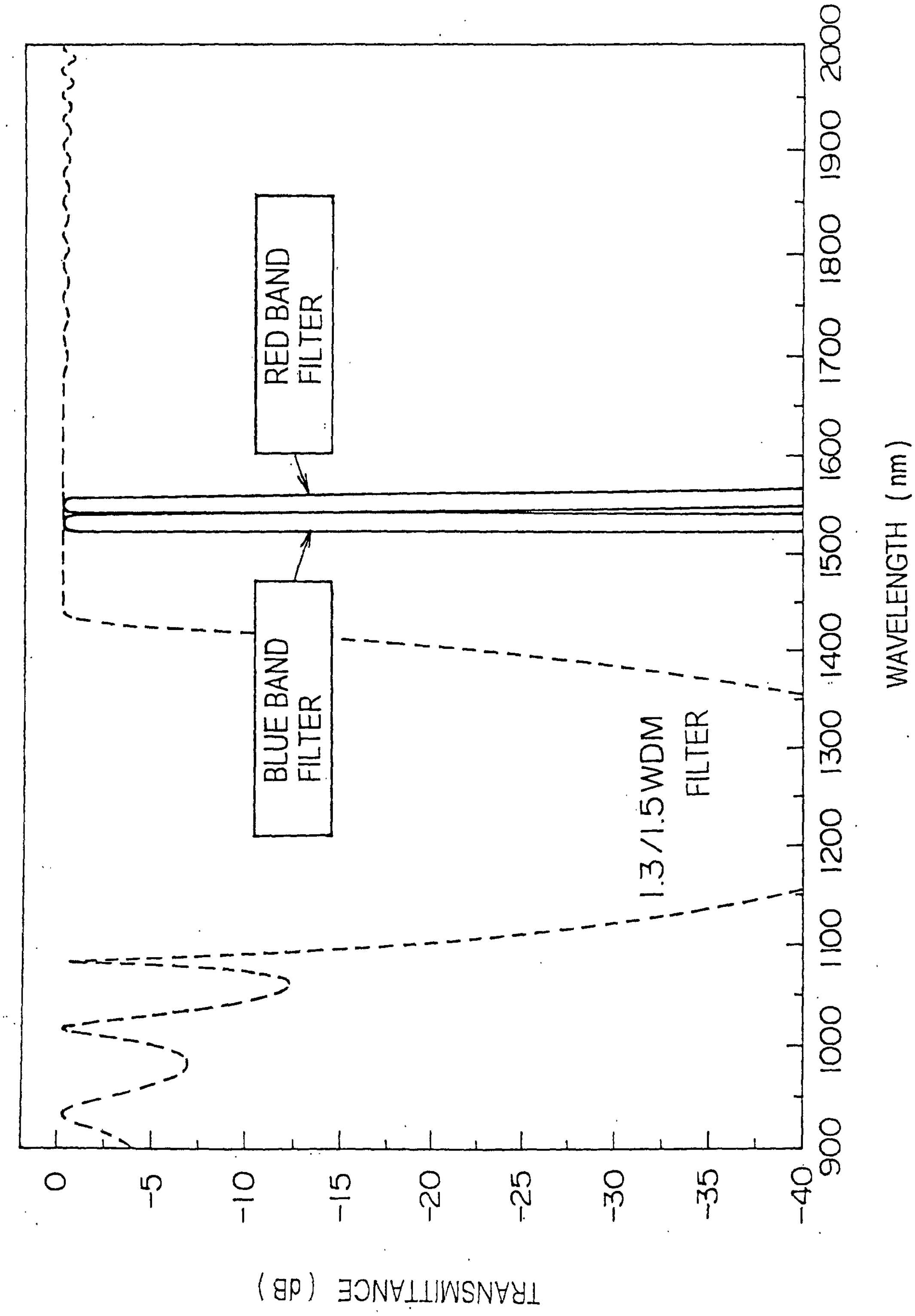
TRANSMITTANCE (dB)
0
-5
-10
-15
-20
-25
-30
-35
-40
900
1000
1100
1200
1300
1400
1500
1600
1700
1800
1900
2000
WAVELENGTH (nm)
1.3/1.5 WDM
FILTER
BLUE BAND
FILTER
RED BAND
FILTER

FIG. 2

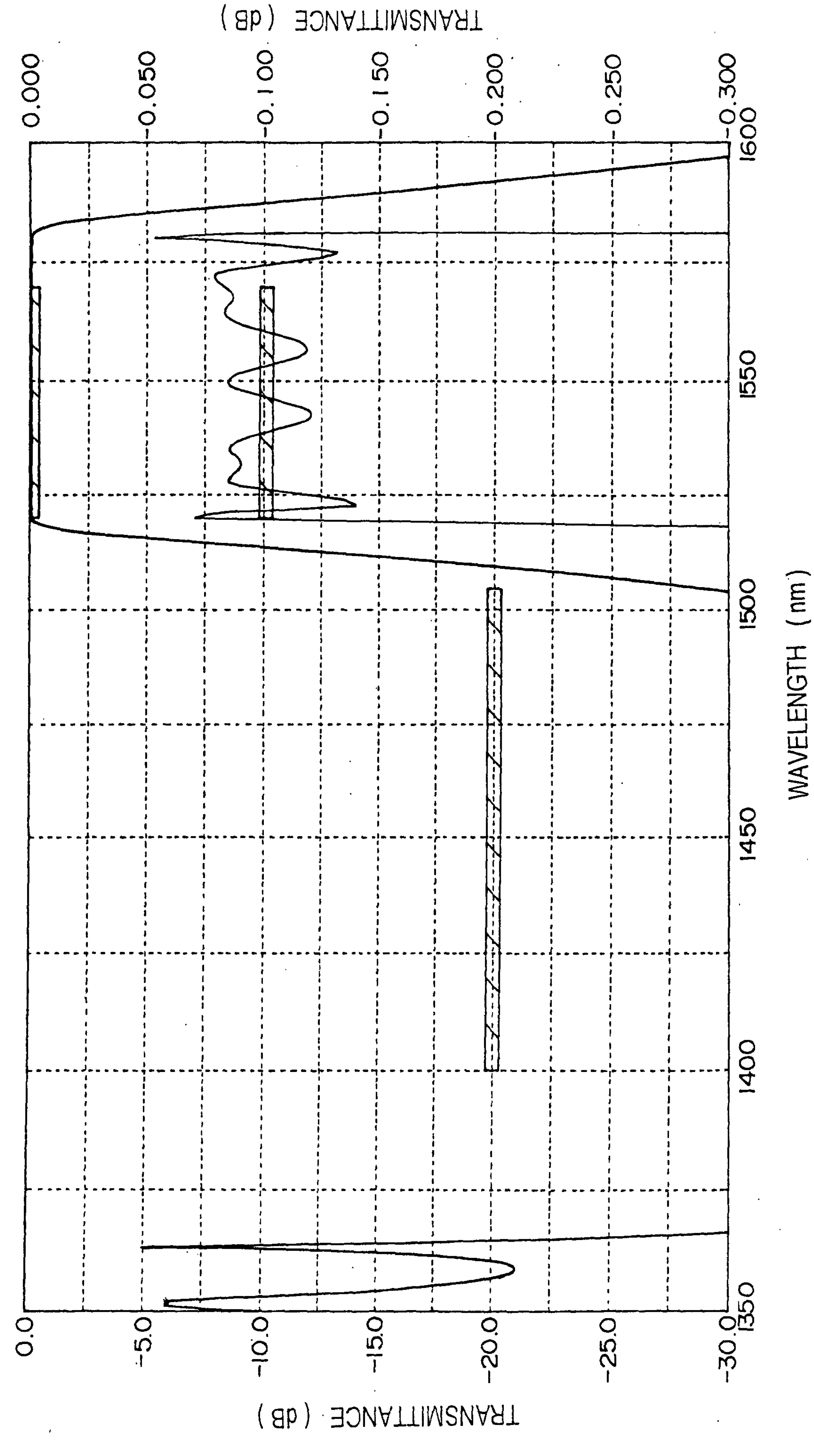
TRANSMITTANCE (dB)
0.000
-0.050
-0.100
-0.150
-0.200
-0.250
-0.300
0.0
-5.0
-10.0
-15.0
-20.0
-25.0
-30.0
1350
1400
1450
1500
1550
1600
WAVELENGTH (nm)
TRANSMITTANCE (dB)

FIG. 3

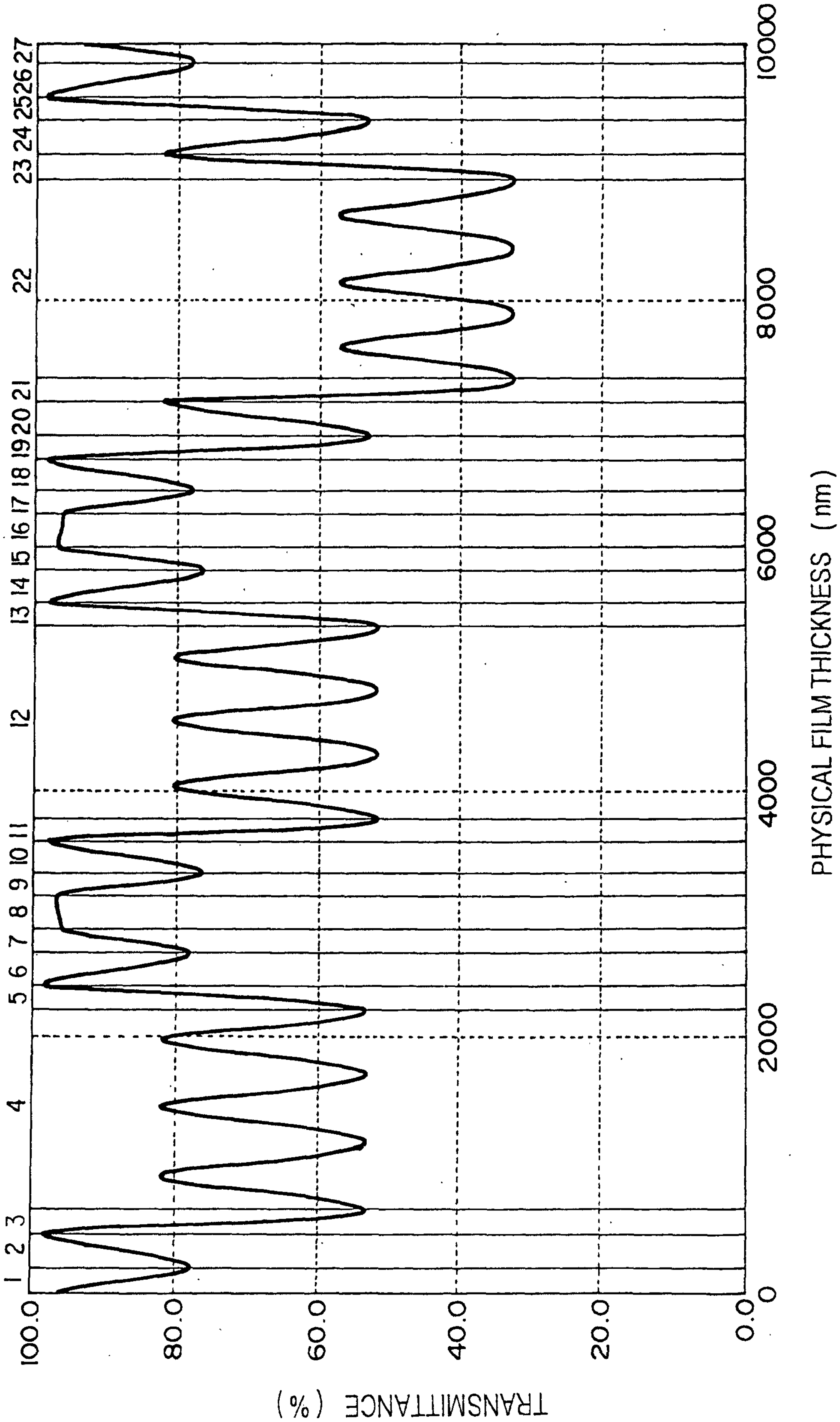
TRANSMITTANCE (%)
100.0
80.0
60.0
40.0
20.0
0.0
PHYSICAL FILM THICKNESS (nm)
0
2000
4000
6000
8000
10000
1 2 3 4 5 6 7 8 9 10 11 12 13 14 15 16 17 18 19 20 21 22 23 24 25 26 27

FIG. 4

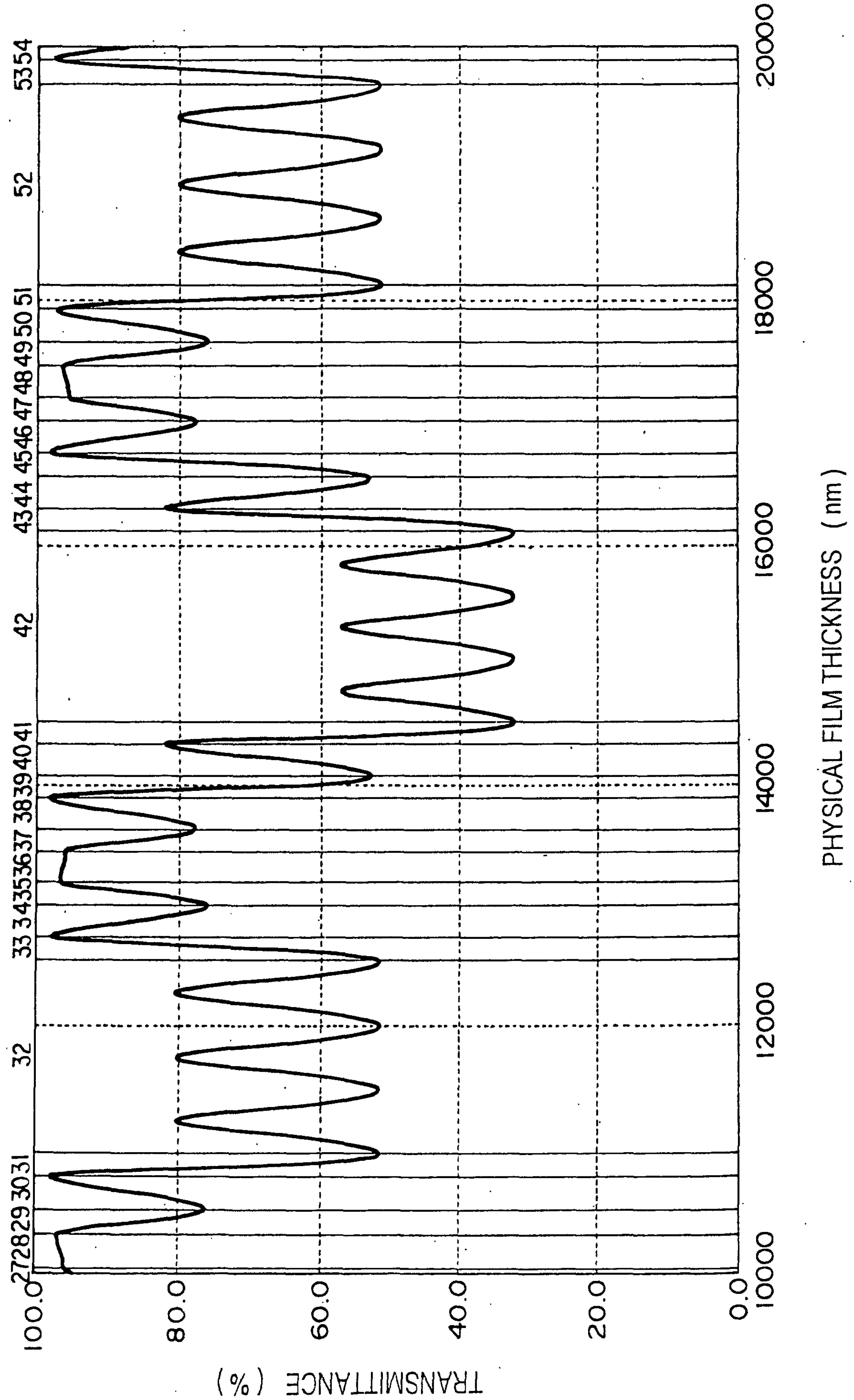
TRANSMITTANCE (%)
100.0
80.0
60.0
40.0
20.0
0.0
10000
12000
14000
16000
18000
20000
PHYSICAL FILM THICKNESS (nm)
27 28 29 30 31
32
33 34 35 36 37 38 39 40 41
42
43 44 45 46 47 48 49 50 51
52
53 54

FIG. 5

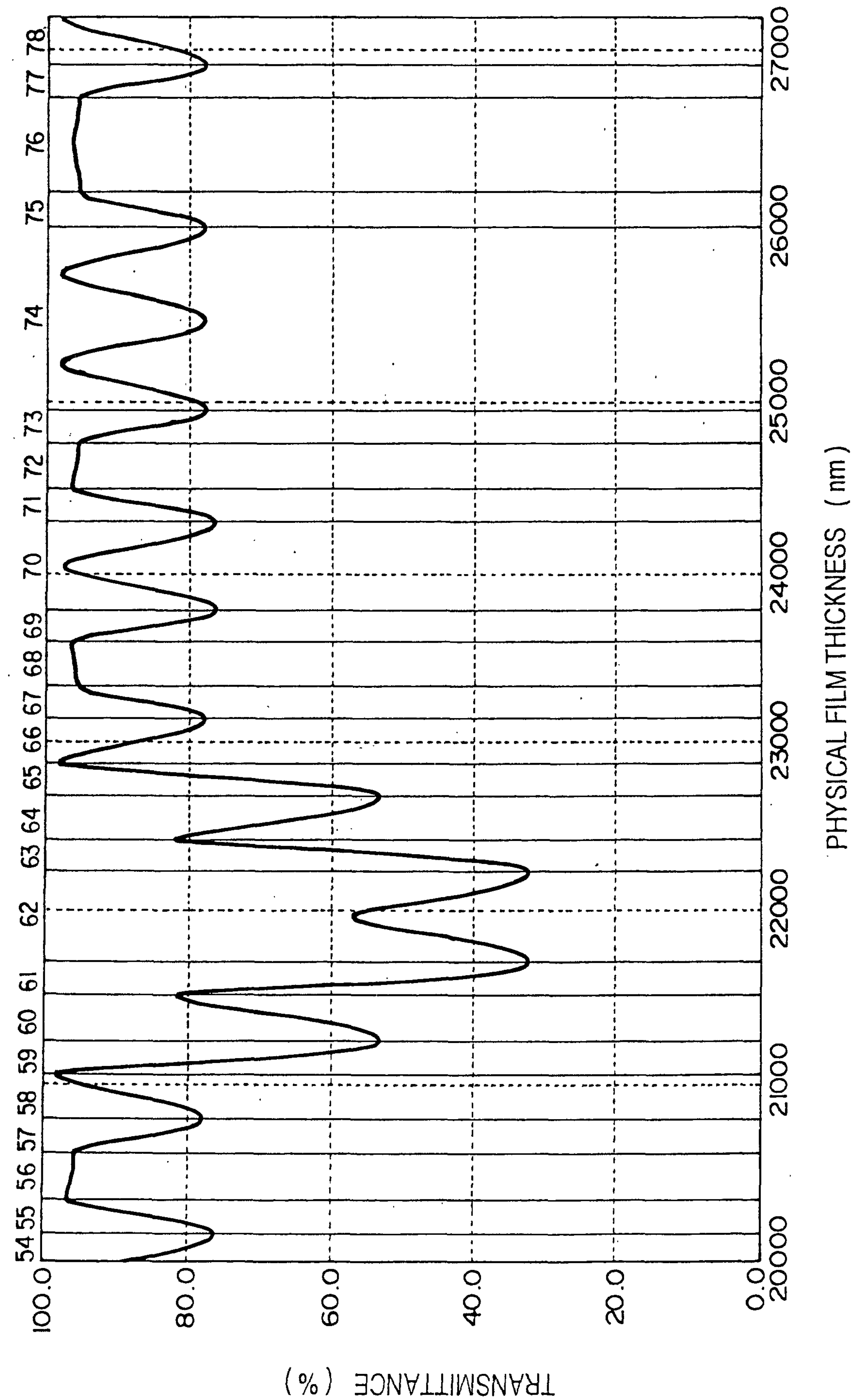
TRANSMITTANCE (%)
100.0
80.0
60.0
40.0
20.0
0.0
20000
21000
22000
23000
24000
25000
26000
27000
PHYSICAL FILM THICKNESS (nm)
54
55
56
57
58
59
60
61
62
63
64
65
66
67
68
69
70
71
72
73
74
75
76
77
78

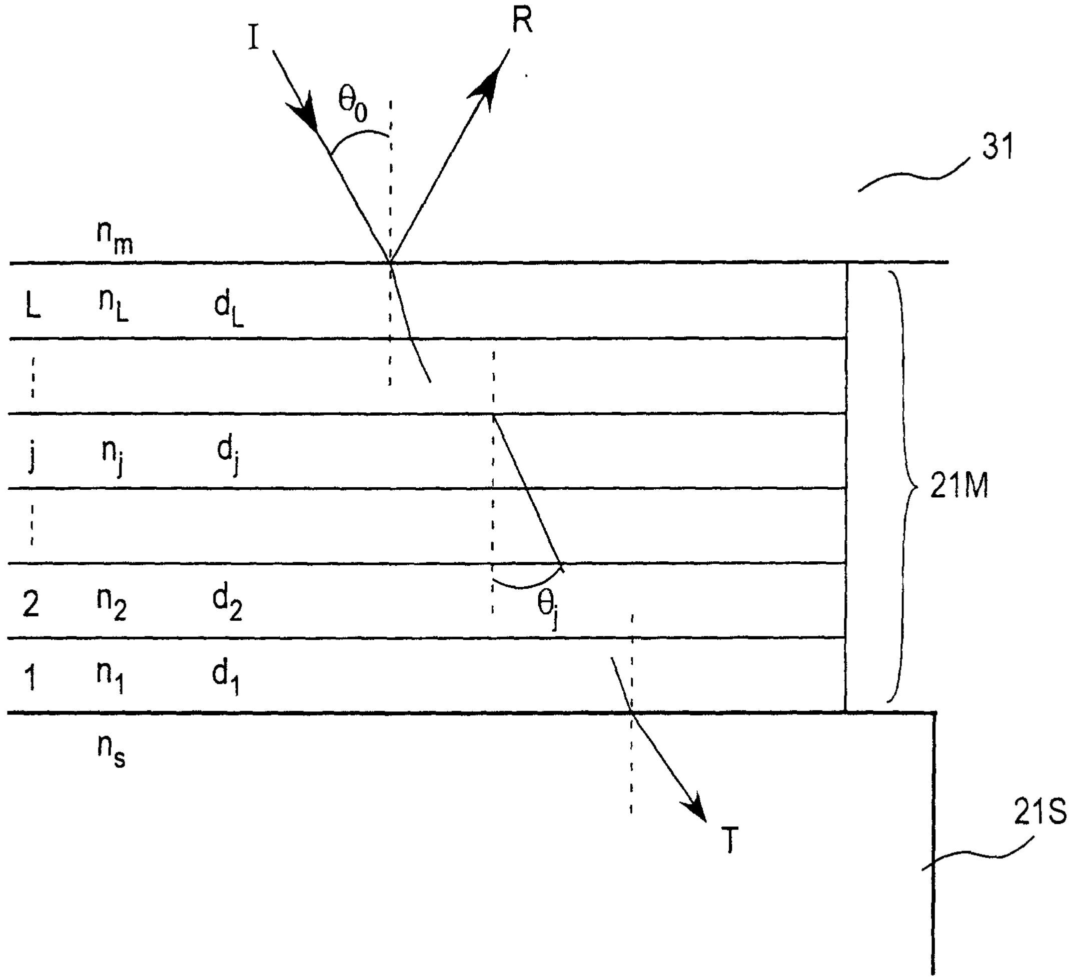


FIG. 6

FIG. 7

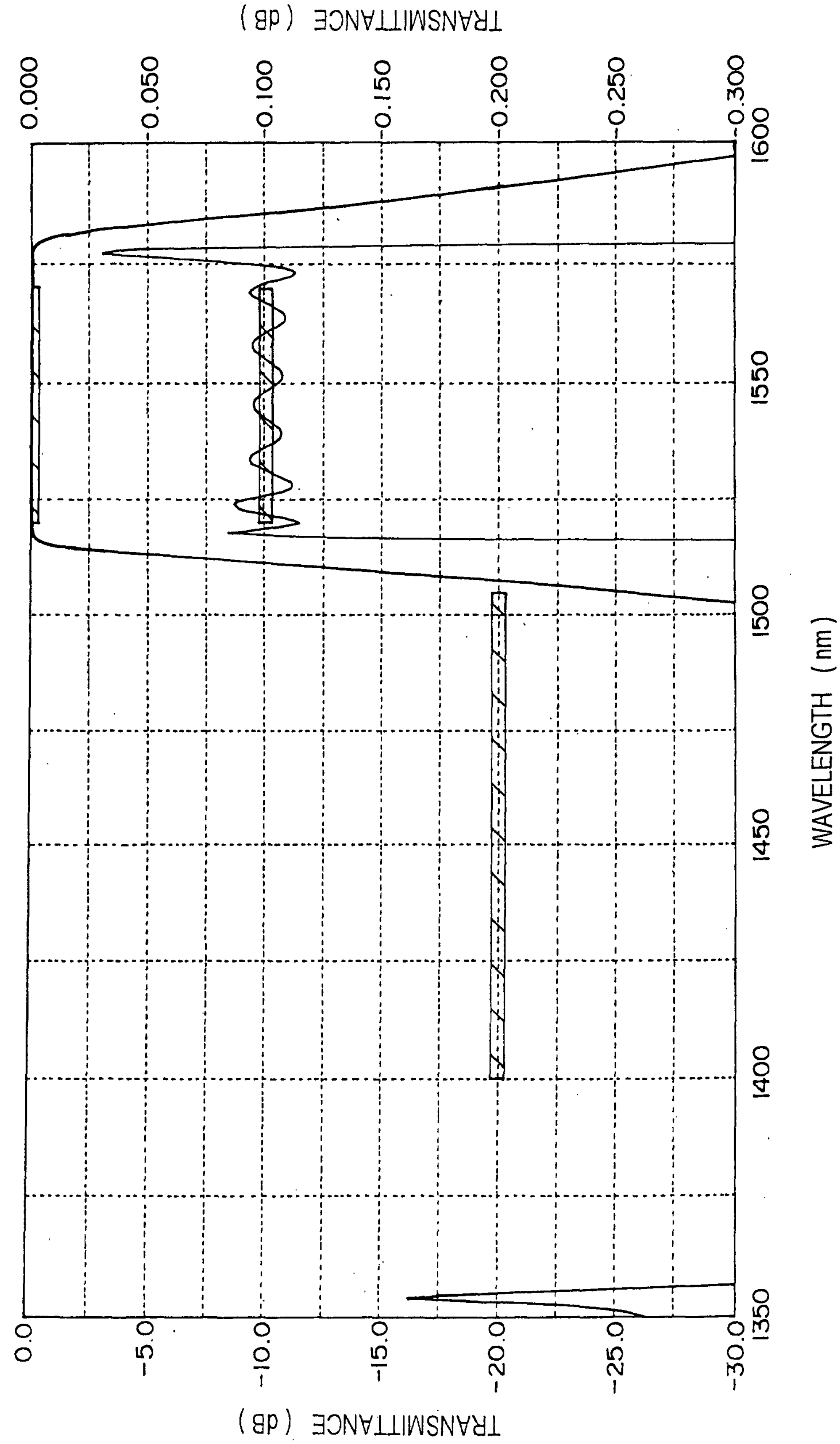
TRANSMITTANCE (dB)
0.000
-0.050
-0.100
-0.150
-0.200
-0.250
-0.300
0.0
-5.0
-10.0
-15.0
-20.0
-25.0
-30.0
1350
1400
1450
1500
1550
1600
WAVELENGTH (nm)
TRANSMITTANCE (dB)

FIG. 8

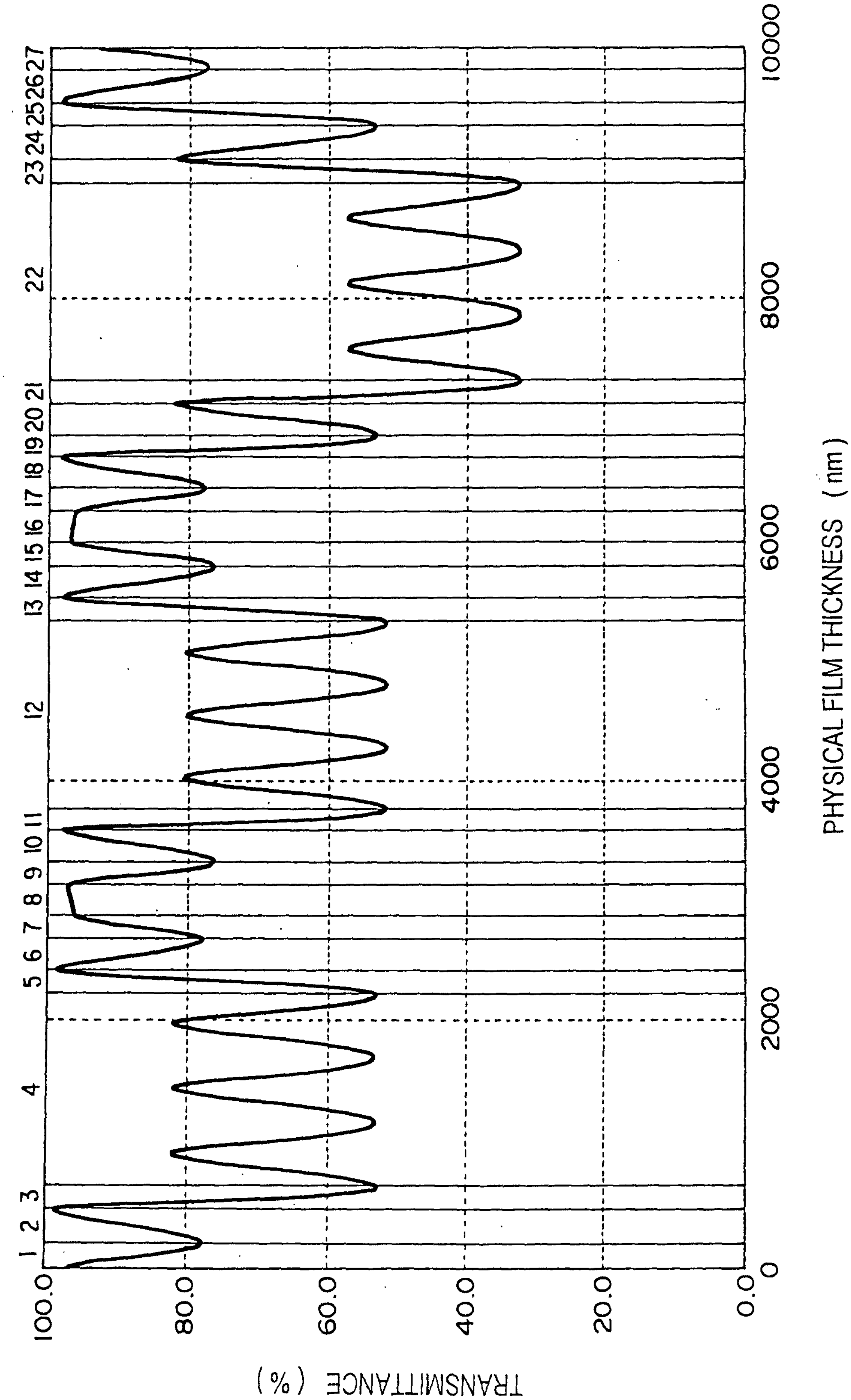
TRANSMITTANCE (%)
100.0
80.0
60.0
40.0
20.0
0.0
0
2000
4000
6000
8000
10000
PHYSICAL FILM THICKNESS (nm)
1 2 3 4 5 6 7 8 9 10 11 12 13 14 15 16 17 18 19 20 21 22 23 24 25 26 27

FIG. 9

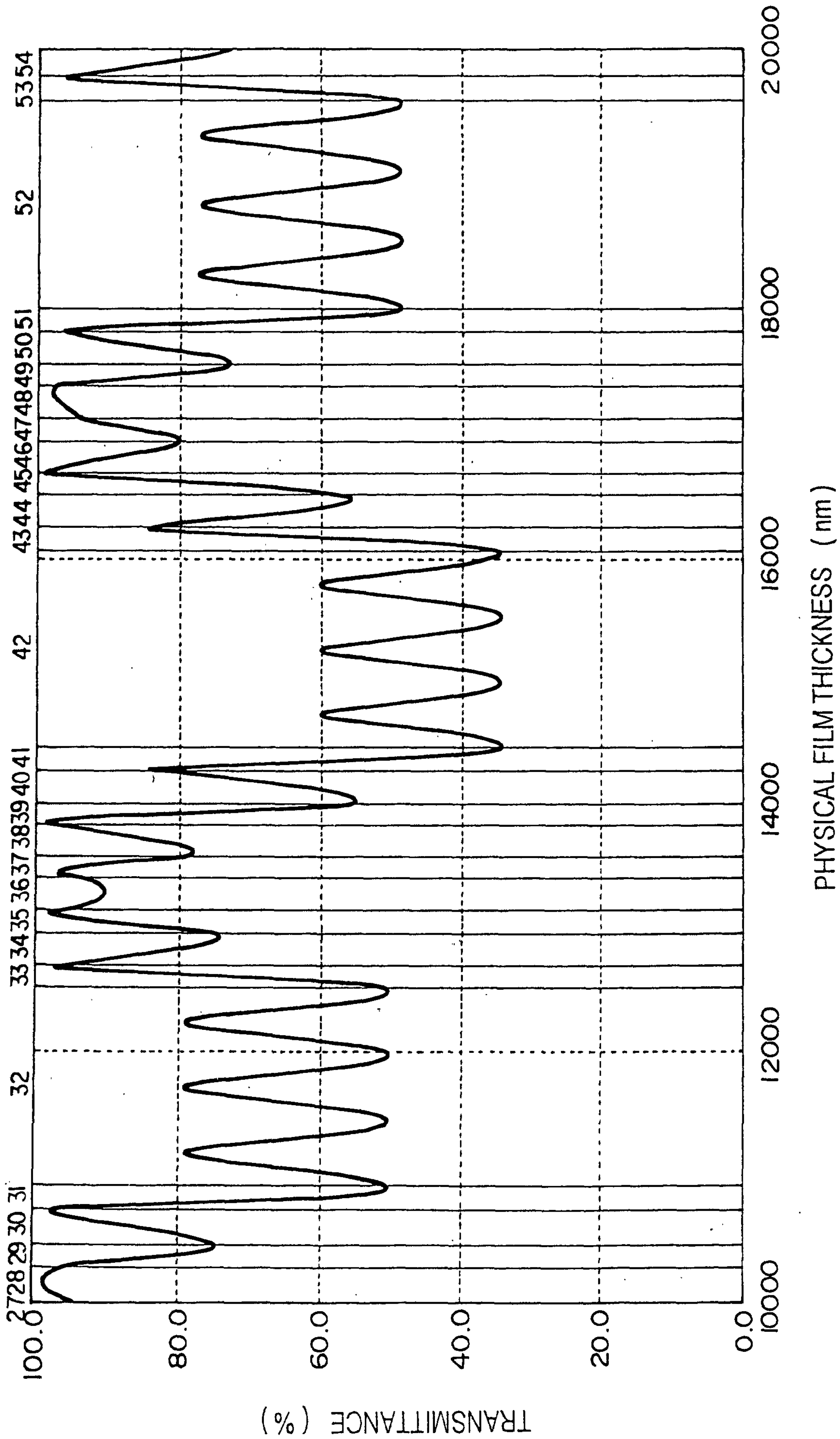
27 28 29 30 31
32
33 34 35 36 37 38 39 40 41
42
43 44 45 46 47 48 49 50 51
52
53 54
100.0
80.0
60.0
40.0
20.0
0.0
TRANSMITTANCE (%)
10000
12000
14000
16000
18000
20000
PHYSICAL FILM THICKNESS (nm)

FIG. 10

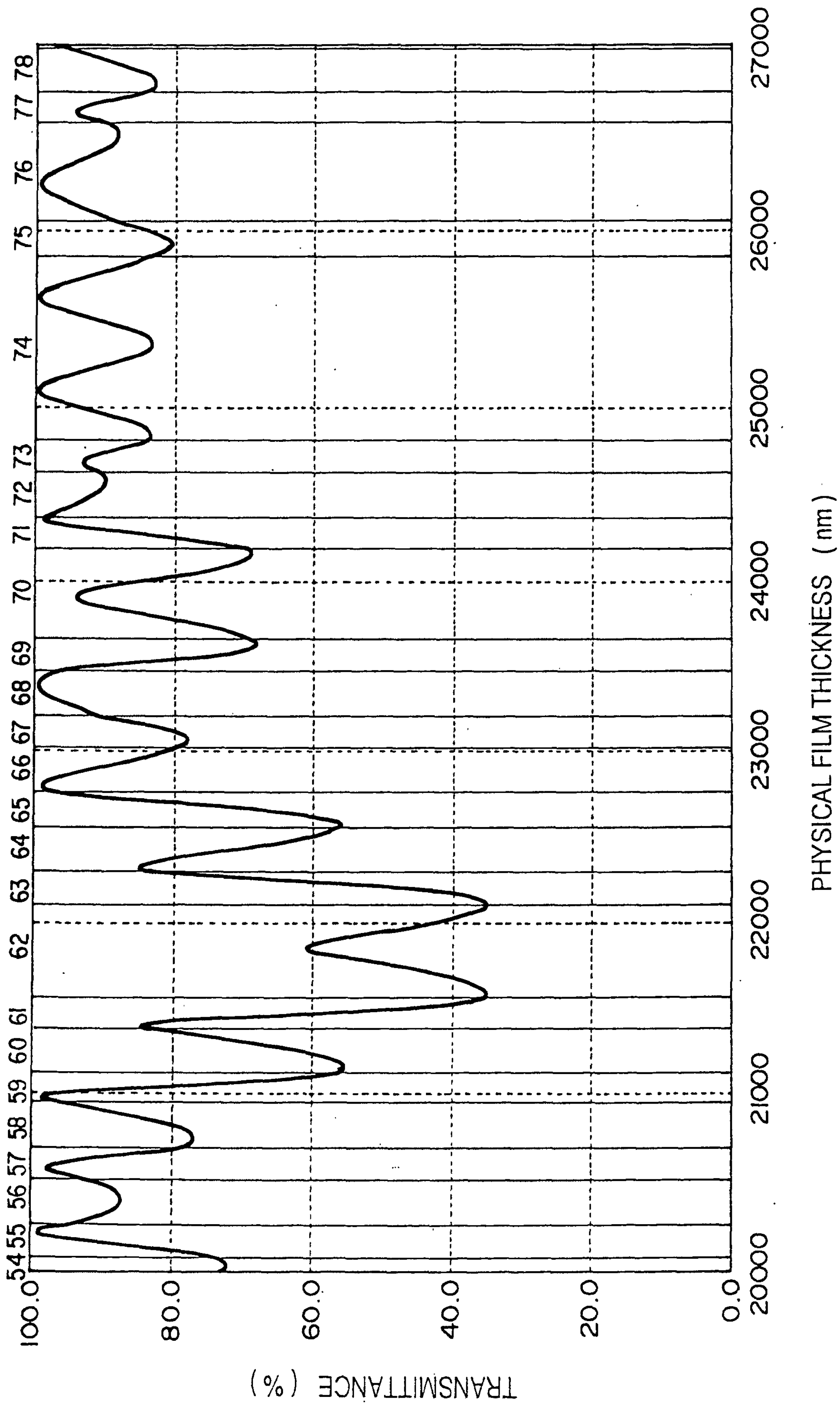
TRANSMITTANCE (%)
100.0
80.0
60.0
40.0
20.0
0.0
PHYSICAL FILM THICKNESS (nm)
20000
21000
22000
23000
24000
25000
26000
27000
54
55
56
57
58
59
60
61
62
63
64
65
66
67
68
69
70
71
72
73
74
75
76
77
78

FIG. 11

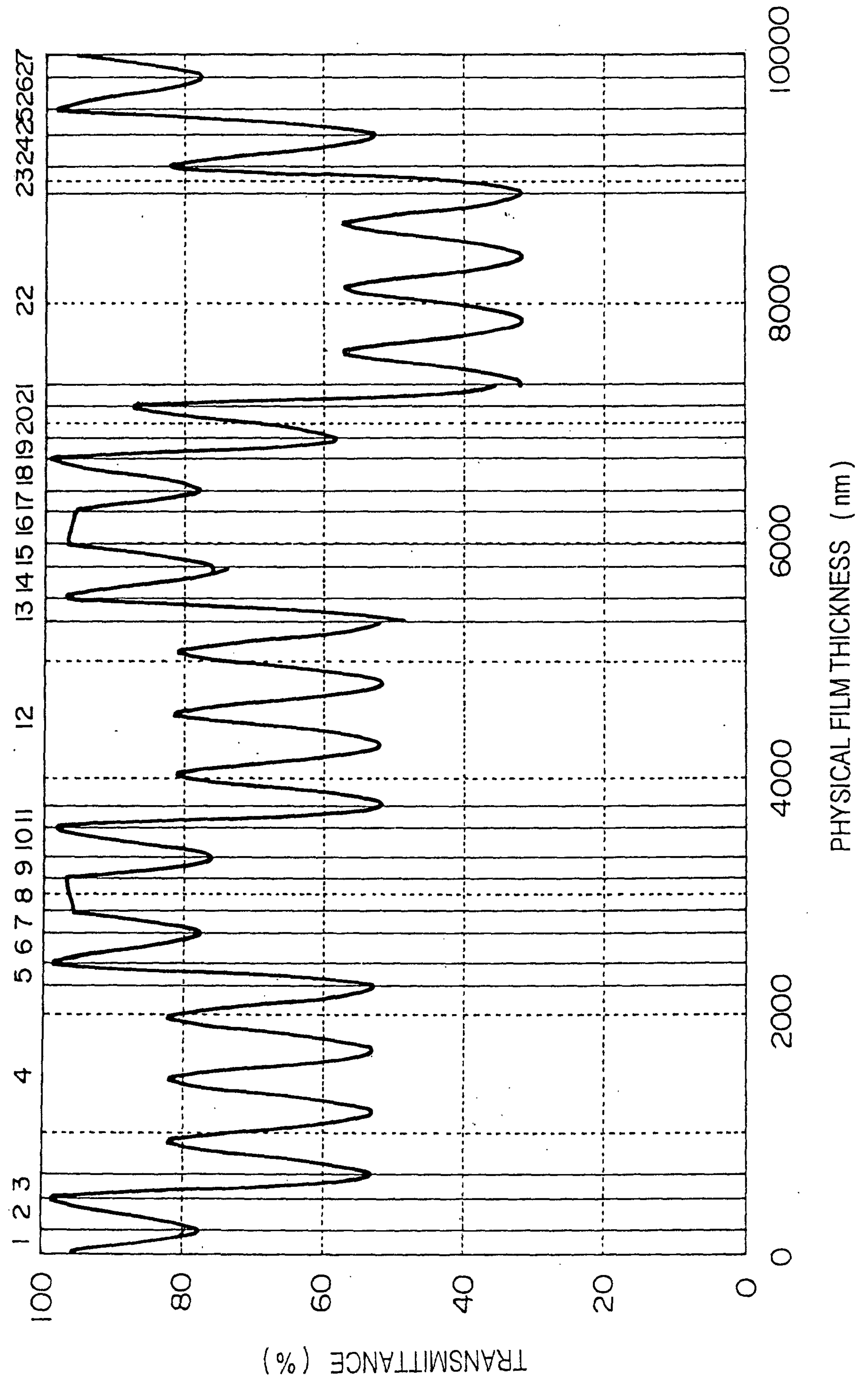
TRANSMITTANCE (%)
100
80
60
40
20
0
PHYSICAL FILM THICKNESS (nm)
0
2000
4000
6000
8000
10000
1 2 3 4 5 6 7 8 9 10 11 12 13 14 15 16 17 18 19 20 21 22 23 24 25 26 27

FIG. 12

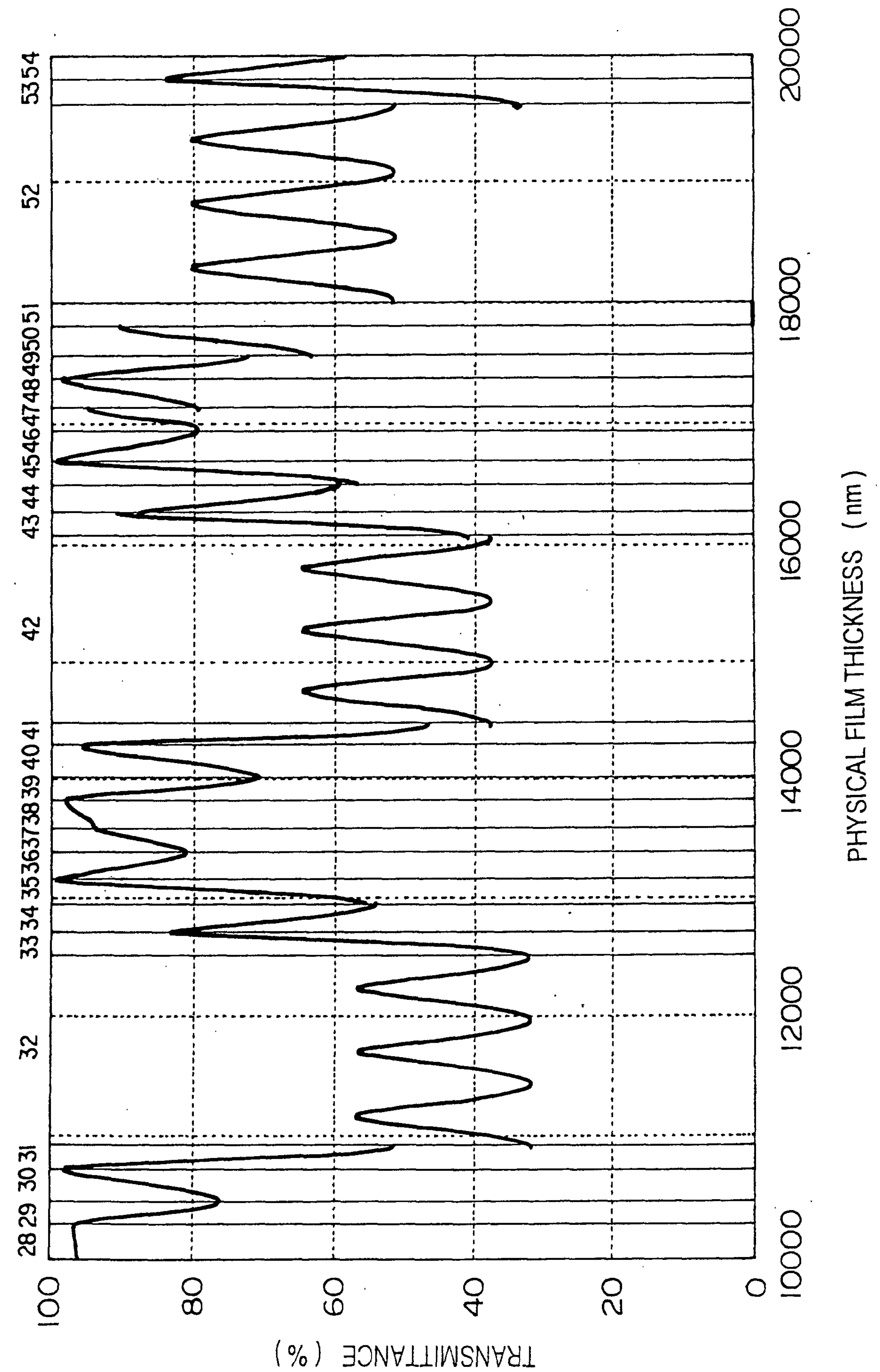
TRANSMITTANCE (%)
100
80
60
40
20
0
PHYSICAL FILM THICKNESS (nm)
10000
12000
14000
16000
18000
20000
28 29 30 31
32
33 34 35 36 37 38 39 40 41
42
43 44 45 46 47 48 49 50 51
52
53 54

FIG. 13

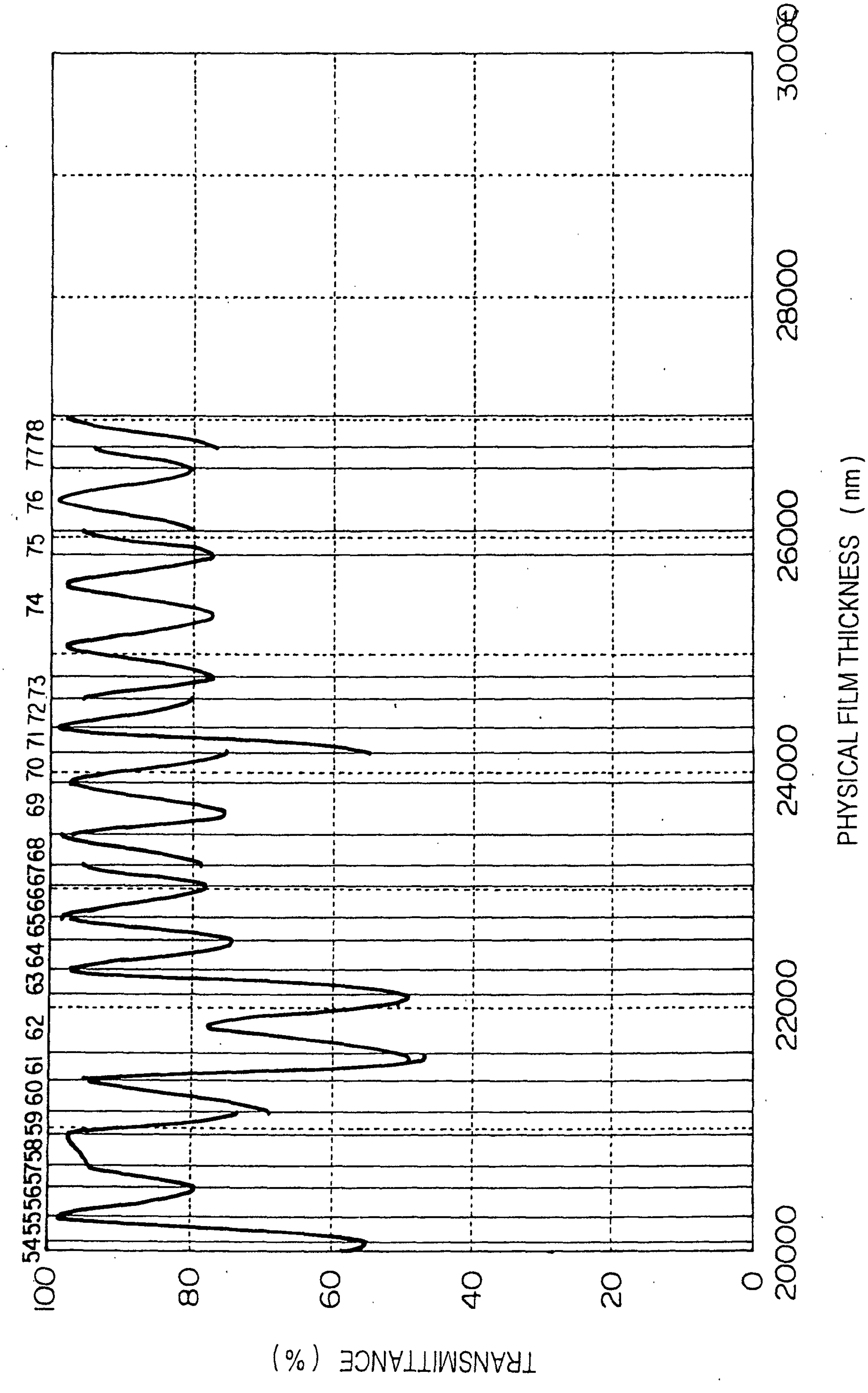
TRANSMITTANCE (%)
100
80
60
40
20
0
PHYSICAL FILM THICKNESS (nm)
20000
22000
24000
26000
28000
30000
54 55 56 57 58 59 60 61 62 63 64 65 66 67 68 69 70 71 72 73 74 75 76 77 78

FIG. 14

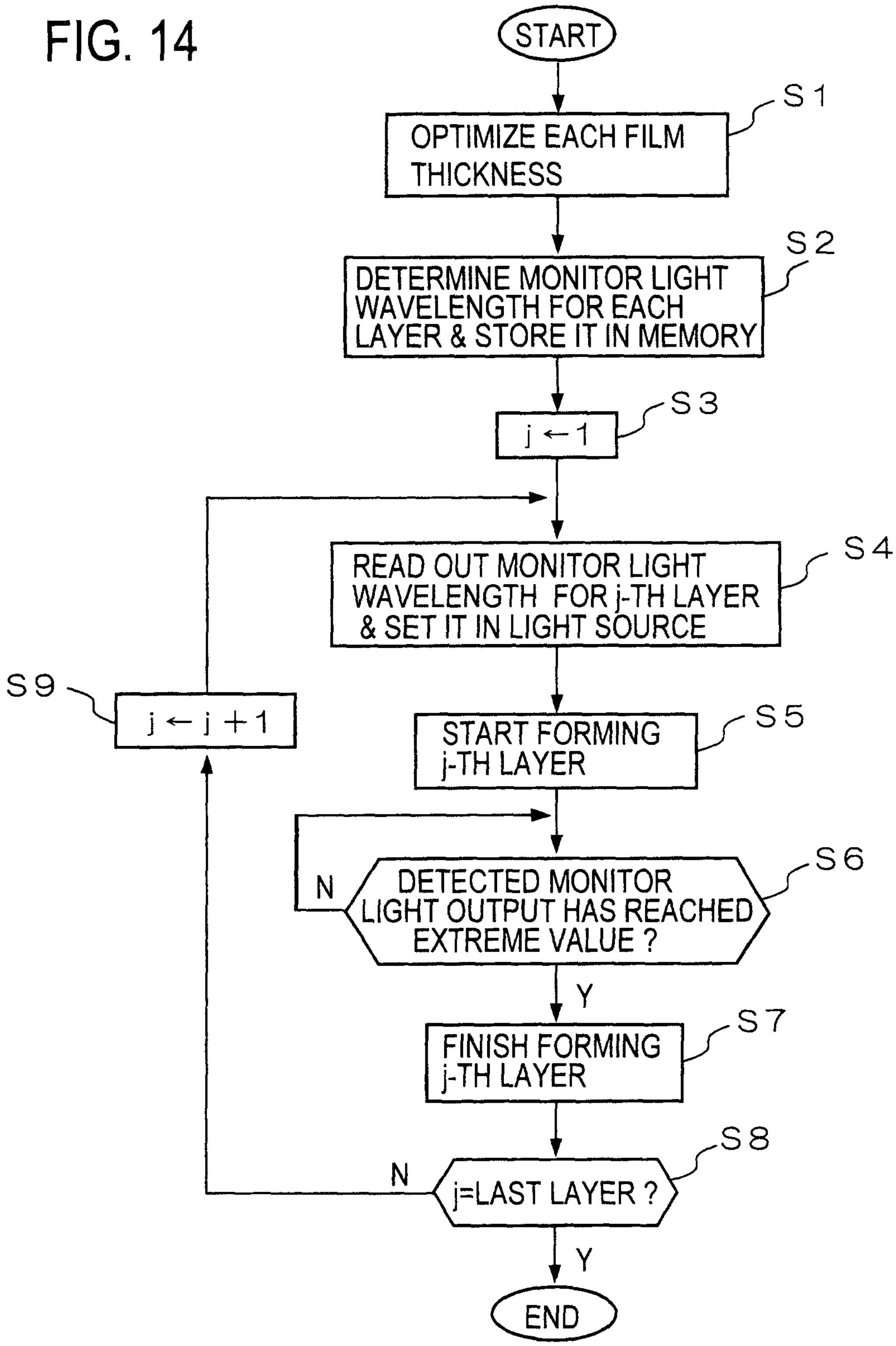
START
S1
OPTIMIZE EACH FILM THICKNESS
S2
DETERMINE MONITOR LIGHT WAVELENGTH FOR EACH LAYER & STORE IT IN MEMORY
S3
j ← 1
S4
READ OUT MONITOR LIGHT WAVELENGTH FOR j-TH LAYER & SET IT IN LIGHT SOURCE
S5
START FORMING j-TH LAYER
S6
DETECTED MONITOR LIGHT OUTPUT HAS REACHED EXTREME VALUE ?
N
Y
S7
FINISH FORMING j-TH LAYER
S8
j=LAST LAYER ?
N
Y
S9
j ← j + 1
END

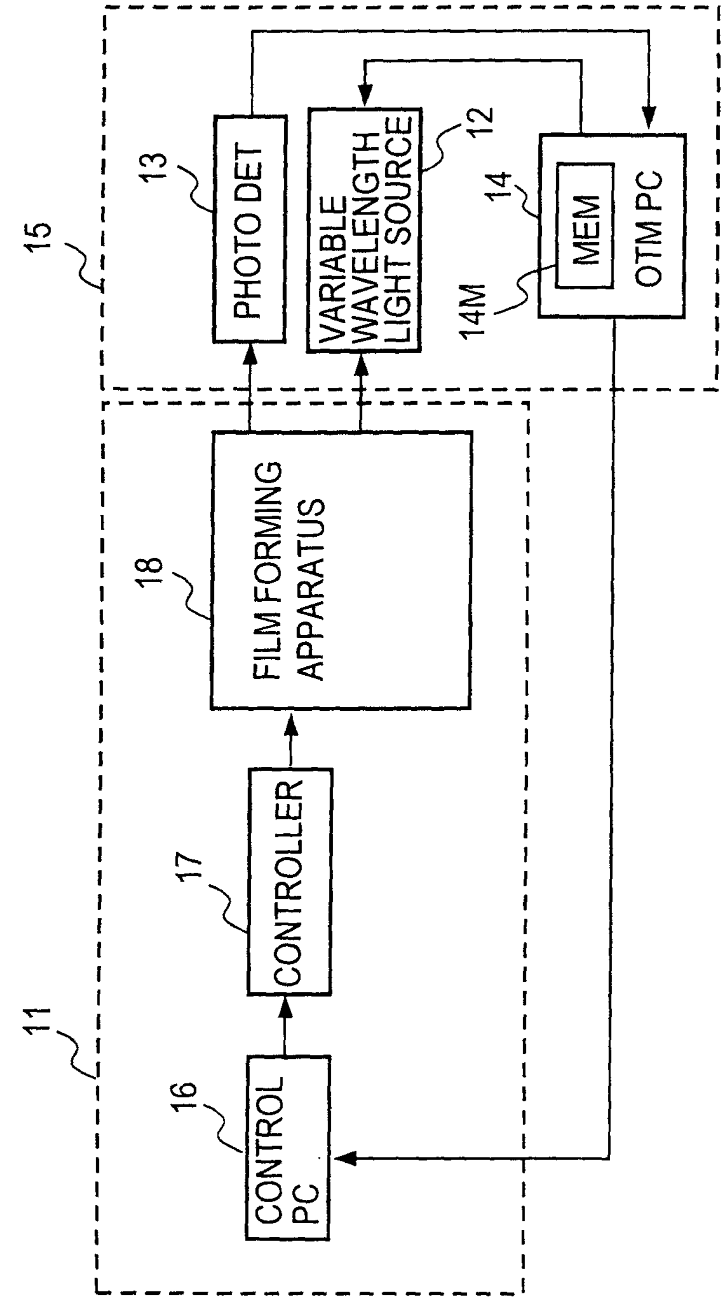
15
13
PHOTO DET
VARIABLE WAVELENGTH LIGHT SOURCE
12
14
MEM
OTM PC
14M
18
FILM FORMING APPARATUS
17
CONTROLLER
11
16
CONTROL PC

FIG. 15

FIG. 16A

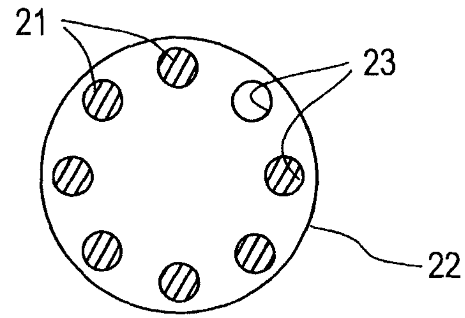


FIG. 16B

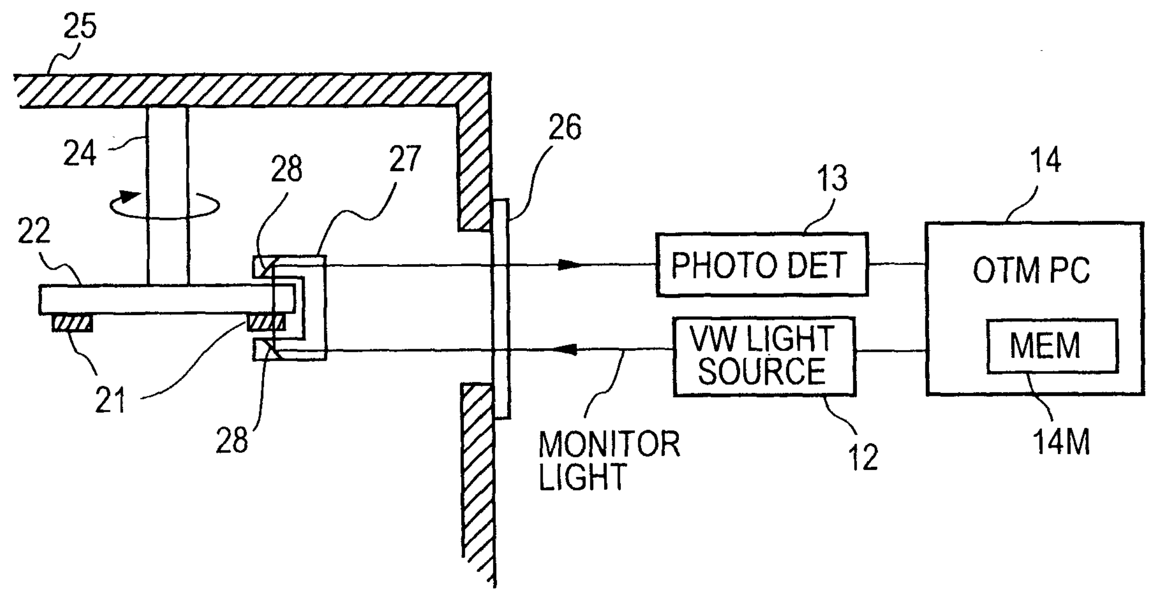

FIG. 17A

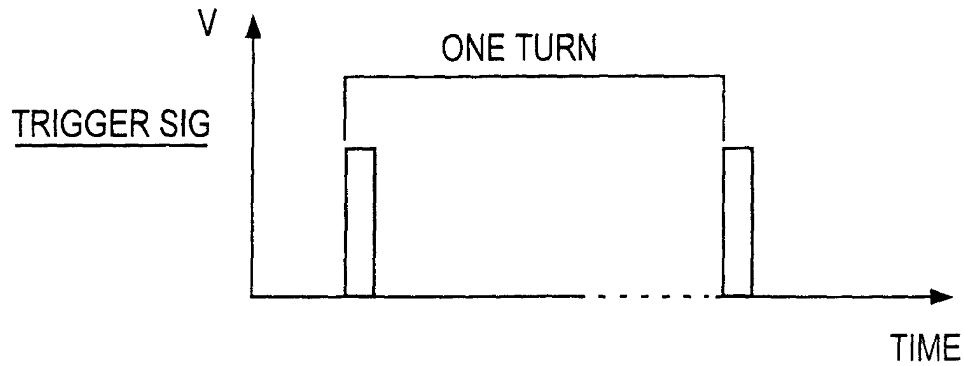


FIG. 17B